# EUROPEAN PATENT APPLICATION

(11) **EP 4 576 089 A1**
(43) Date of publication of application: **25.06.2025**
(21) Application number: 24186236.6
(22) Date of filing: 03.07.2024
(51) Int. Cl.: G11C 7/10, G11C 11/406

(54) **MEMORY SYSTEM AND MEMORY CHIP**

(30) Priority: 19.12.2023 US 202363611806 P
(71) Applicant: Etron Technology, Inc., Hsinchu 30078 (TW)
(72) Inventor: Shiah, Chun, 300 Hsinchu City (TW)
(74) Representative: Straus, Alexander

(57) **Abstract**

A memory chip includes a memory bank, I/O data bus, and a first plurality of sensing amplifiers. The first plurality of sensing amplifiers are between the memory bank and the I/O data bus and configured to output a first plurality of data in parallel to the I/O data bus. There is no parallel-to-serial circuit and no serial-to- parallel circuit in the memory chip.

## Description

### Field of the Invention

The present invention relates to a memory system and a memory chip according to claims 1, 13, 19, 21.

### Background of the Invention

Nowadays, a memory system for high performance computing or artificial intelligence (AI) system usually includes dynamic random access memory (DRAM) chips and a logic circuit. Due to stacked structures of the DRAM chips, scaling of the DRAM chips cannot follow scaling of the logic circuit. Therefore, a memory-wall effect occurs to result in data transmission rates between the logic circuit and the DRAM chips being reduced. To overcome the memory-wall effect, the prior art usually 1) utilizes faster data rate (e.g., from DDR3 to DDR4 or DDR5) to transmit data between the DRAM chips and the logic circuit, or 2) utilizes wide data bus of the logic circuit and wide data bus of the DRAM chips (e.g. HBM) to transmit data between the DRAM chips and the logic circuit. However, the faster data rate has disadvantages (e.g. more expensive tester, less noise margin, and so on), and the wide data bus of the logic circuit and the wide data bus of the DRAM chips also have disadvantages (e.g. higher power, larger die area, and expensive Through-Silicon Via ("TSV") process, and so on). And no matter the aforesaid faster data rate of the DRAM or the wider data bus of the DRAM, all need serial-to-parallel circuit and parallel-to-serial circuit which increases clock latencies and power consumption.

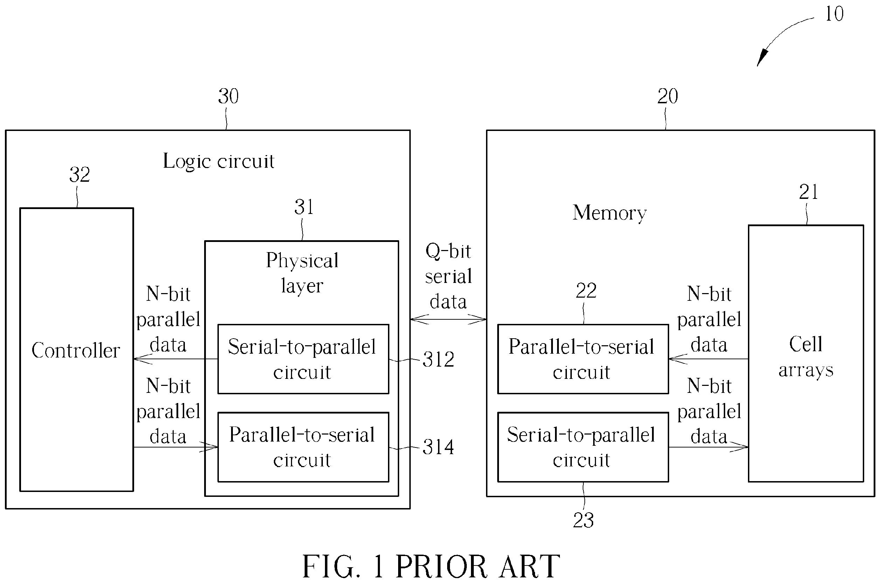

Please refer to FIG. 1. FIG. 1 is a diagram illustrating a memory system 10 according to the prior art. As shown in FIG. 1, the memory system 10 includes a memory 20 and a logic circuit 30, wherein the memory 20 is a dynamic random access memory (DRAM). As shown in FIG. 1, the memory 20 includes cell arrays 21, a parallel-to-serial circuit 22, and a serial-to-parallel circuit 23; the logic circuit 30 includes a physical layer (PHY) 31 and a controller 32, and the physical layer 31 also includes a serial-to-parallel circuit 312, and a parallel-to-serial circuit 314. In addition, of course, the logic circuit 30 further includes other functional circuits (not shown in FIG. 1), wherein the other functional circuits can include central processing units (CPUs), digital signal processors (DSPs), peripheral interfaces, and so on. As shown in FIG. 1, when the logic circuit 30 writes data into the memory 20, the parallel-to-serial circuit 314 can receive the data (e.g. N-bit data) from the controller 32 in parallel, convert the N-bit data into groups of Q-bit data, wherein Q is less than N, and transmit the groups of Q-bit data to the serial-to-parallel circuit 23; the serial-to-parallel circuit 23 can receive the groups of Q-bit data from the parallel-to-serial circuit 314, convert groups of Q-bit data into the N-bit data, and transmit the N-bit data to the cell arrays 21 in parallel. In addition, when the logic circuit 30 reads the data from the memory 20, the parallel-to-serial circuit 22 can receive the data (e.g. the N-bit data) from the cell arrays 21 in parallel, convert the N-bit data into the groups of Q-bit data, and transmit the groups of Q-bit data to the serial-to-parallel circuit 312; the serial-to-parallel circuit 312 can receive the groups of Q-bit data from the parallel-to-serial circuit 22, convert the groups of Q-bit data into the N-bit data, and transmit the N-bit data to the controller 32 in parallel.

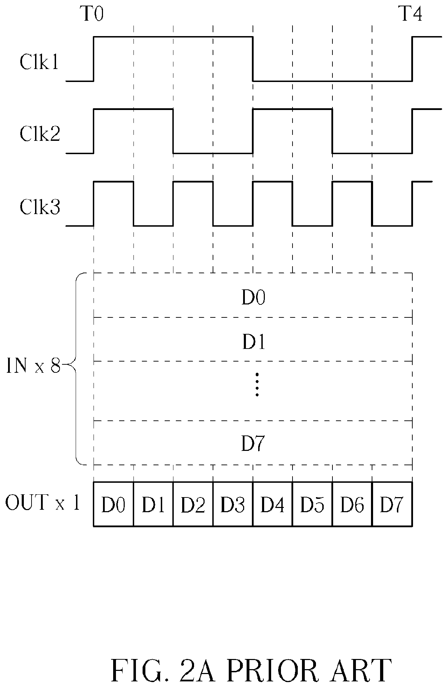

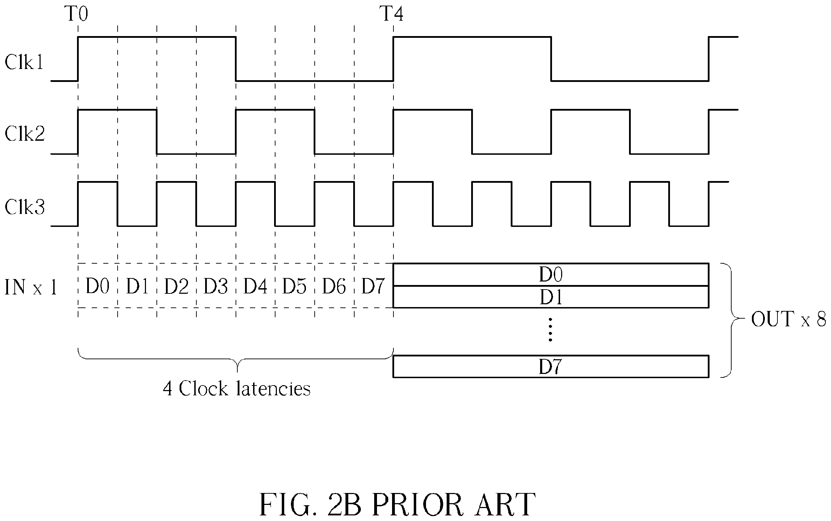

Please refer to FIGS. 2A, 2B. FIGS. 2A, 2B are diagrams illustrating timing diagrams corresponding to the logic circuit 30 writing the data into the memory 20. As shown in FIG. 2A, taking the logic circuit 30 writing 8-bit data D0-D7 into the memory 20 as an example, when the logic circuit 30 writes the 8-bit data D0-D7 into the memory 20, registers (not shown in FIG. 1) of the parallel-to-serial circuit 314 may use three signals clk1, clk2, clk3 to transmit the parallel 8-bit data D0-D7 to the serial-to-parallel circuit 23 in serial. For example, when clk1=1, clk2= 1, clk3=1, the parallel-to-serial circuit 314 transmits the datum D0 to the serial-to-parallel circuit 23, when clk1=1, clk2=1, clk3=0, the parallel-to-serial circuit 314 transmits the datum D1 to the serial-to-parallel circuit 23... , and so on. Therefore, the parallel-to-serial circuit 314 starts to transmit the datum D0 at a time T0, and finally transmit the datum D7 at a time T4.

As shown in FIG. 2B, similarly, registers (not shown in FIG. 1) of the serial-to-parallel circuit 23 may also use similar clock signals clk1, clk2, clk3 to process 8-bit data D0-D7 in serial from the parallel-to-serial circuit 314. As shown in FIG. 2B, when clk1=1, clk2= 1, clk3=1, the serial-to-parallel circuit 23 receives the datum D0 from the parallel-to-serial circuit 314, when clk1=1, clk2=1, clk3=0, the serial-to-parallel circuit 23 receives the datum D1 from the parallel-to-serial circuit 314..., and so on). Therefore, the serial-to-parallel circuit 23 starts to receive the datum D0 at a time T0, and finally receives the datum D7 at a time T4, wherein 4 clock latencies of the clock clk3 exist between the time T0 and the time T4. That is, the serial-to-parallel circuit 23 only starts to transmit the 8-bit data D0-D7 to the cell arrays 21 in parallel after the serial-to-parallel circuit 23 waits for the 4 clock latencies.

Although the prior art can reduce the 4 clock latencies (e.g. 3.5 clock latencies) by optimizing the memory system 10, the above-mentioned serial-to-parallel converting process executed by the serial-to-parallel circuit 23 and the above-mentioned parallel-to-serial converting process executed by the parallel-to-serial circuit 314 would cost extra power, transmission latencies, and die areas, result in low efficiencies of the memory system 10. Therefore, how to reduce cost of the power, transmission latencies, and die areas becomes an important issue for a designer of the memory system.

### Summary of the Invention

The present invention aims at providing a memory system and a memory chip that can let data be transmitted between a logic circuit and the memory chip in parallel

This is achieved by a memory system and a memory chip according to claims 1, 13, 19, 21. The dependent claims pertain to corresponding further developments and improvements.

As will be seen more clearly from the detailed description following below, the claimed memory chip memory chip which could be a DRAM chip, SRAM chip, or other types of memory chips includes a memory bank, I/O data bus, and a first plurality of sensing amplifiers. The first plurality of sensing amplifiers are between the memory bank and the I/O data bus and configured to output a first plurality of data in parallel to the I/O data bus. There is no parallel-to-serial circuit and no serial-to- parallel circuit in the memory chip.

According to one aspect of the invention, the memory chip sends out a handshaking signal to selectively notice whether the memory chip does not execute a refresh operation.

According to one aspect of the invention, the memory chip further includes an extra output pin, wherein the handshaking signal is sent to a memory controller through the extra output pin, wherein the memory controller is physically separate from the memory chip.

According to one aspect of the invention, the memory chip further includes a refresh counter, wherein the handshaking signal is selectively active according to number of clocks counted by the refresh counter.

According to one aspect of the invention, the handshaking signal is active when the DRAM chip is executing the refresh operation, and the handshaking signal is non-active when the DRAM chip does not execute the refresh operation.

According to one aspect of the invention, a width of the I/O data bus is equal to a width of the first plurality of data parallelly outputted by the first plurality of sensing amplifiers.

According to one aspect of the invention, the memory chip further includes a plurality of transceivers between the first plurality of sensing amplifiers and the I/O data bus, wherein the plurality of transceivers parallelly receive and transmit the first plurality of data from the first plurality of sensing amplifiers to the I/O data bus.

According to one aspect of the invention, the memory chip further includes a second plurality of sensing amplifiers between the memory bank and the first plurality of sensing amplifiers, wherein the second plurality of sensing amplifiers include M sensing amplifiers and are connected to bit lines of the memory chip, the first plurality of sensing amplifiers comprise N sensing amplifiers and are connected to data lines of the memory chip, both N and M are positive integers, and M is not less than N.

According to one aspect of the invention, a portion of the second plurality of sensing amplifiers are selectively coupled to the first plurality of sensing amplifiers, and the portion of the second plurality of sensing amplifiers parallelly output the first plurality of data to the first plurality of sensing amplifiers; wherein a number of sensing amplifiers in the portion of the second plurality of sensing amplifiers is equal to N.

According to one aspect of the invention, the portion of the second plurality of sensing amplifiers are selectively coupled to the first plurality of sensing amplifiers according to a control signal inputted to the memory chip.

According to one aspect of the invention, the control signal includes a plurality of signal bits configured to be stored in a register of the memory chip.

According to one aspect of the invention, the memory chip further includes a plurality of bit switches between the first plurality of sensing amplifiers and the second plurality of sensing amplifiers, wherein the plurality of bit switches electrically connect to the portion of the second plurality of sensing amplifiers and the first plurality of sensing amplifiers according to the control signal.

Another embodiment of the present invention provides a memory chip. The memory chip includes a plurality of memory banks, data lines, a plurality set of sensing amplifiers, and an I/O data bus. The plurality set of sensing amplifiers are coupled to the data lines, wherein each set of sensing amplifiers is corresponding to one of the plurality of memory banks and is configured to parallelly output a plurality of data. There is no parallel-to-serial circuit and no serial-to-parallel circuit in the memory chip, and the memory chip sends out a handshaking signal to selectively notice whether the memory chip does not execute a refresh operation.

According to one aspect of the invention, the memory chip further includes an extra output pin, wherein the handshaking signal is sent to a memory controller through the extra output pin, wherein the memory controller is physically separate from the memory chip.

According to one aspect of the invention, the handshaking signal is active when the DRAM chip is executing the refresh operation, and the handshaking signal is non-active when the DRAM chip does not execute the refresh operation.

According to one aspect of the invention, the memory chip further includes a refresh counter, wherein the handshaking signal is selectively active according to number of clocks counted by the refresh counter.

According to one aspect of the invention, the plurality of memory banks include a first memory bank and a second memory bank; the plurality set of sensing amplifiers include a first set of sensing amplifiers coupled to the data lines and a second set of sensing amplifiers coupled to the data lines; the first set of sensing amplifiers are corresponding to the first memory bank and configured to parallelly output a first plurality of data, and the second set of sensing amplifiers are corresponding to the second memory bank and configured to parallelly output a second plurality of data; and the width of the I/O data bus is equal to the sum of the width of the first plurality of data and the width of the second plurality of data.

According to one aspect of the invention, the memory chip further includes bit lines, a third set of sensing amplifiers, and a fourth set of sensing amplifiers. The third set of sensing amplifiers is coupled to the bit lines and configured between the first memory bank and the first set of sensing amplifiers. The fourth set of sensing amplifiers is coupled to the bit lines and configured between the second memory bank and the second set of sensing amplifiers. A portion of the third set of sensing amplifiers are selectively coupled to the first set of sensing amplifiers, and a number of sensing amplifiers in the portion of the third set of sensing amplifiers is equal to a number of sensing amplifiers in the first set of sensing amplifiers. A portion of the fourth set of sensing amplifiers are selectively coupled to the second set of sensing amplifiers, and a number of sensing amplifiers in the portion of the fourth set of sensing amplifiers is equal to a number of sensing amplifiers in the second set of sensing amplifiers.

According to one aspect of the invention, the portion of the third set of sensing amplifiers are selectively coupled to the first set of sensing amplifiers according to a control signal inputted to the memory chip, and the portion of the fourth set of sensing amplifiers are selectively coupled to the second set of sensing amplifiers according to the control signal.

Another embodiment of the present invention provides a memory controller for a DRAM system, the DRAM system includes a system bus interface and a memory chip, and the memory chip includes an I/O data bus. The memory controller includes a control circuit and a physical layer circuit. The control circuit is configured to couple to the system bus interface. The physical layer circuit is coupled to control circuit and configured to parallelly receive a first plurality of data from the I/O data bus of the memory chip. There is no serial-to-parallel circuit and no parallel-to-serial circuit in the physical layer circuit of the memory controller.

According to one aspect of the invention, the physical layer circuit is further configured to parallelly output a second plurality of data to the I/O data bus of the memory chip.

According to one aspect of the invention, the memory controller receives a handshaking signal from the memory chip to selectively notice the memory controller whether the memory chip does not execute a refresh operation.

According to one aspect of the invention, handshaking signal is active when the DRAM chip is executing the refresh operation, and the handshaking signal is non-active when the DRAM chip does not execute the refresh operation.

According to one aspect of the invention, when the handshaking signal is active, the memory controller holds an access command which is intended to read data from or write data to the memory chip.

According to one aspect of the invention, the memory controller sends the held access command to the memory chip after the handshaking signal is non-active.

Another embodiment of the present invention provides a memory system. The memory system includes a system bus interface, a memory controller, a memory chip, and a substrate. The memory controller has a controller I/O data bus coupled to a plurality of second bump groups, wherein the memory controller is coupled to the system bus interface, the memory controller further includes a physical layer, and there is no parallel-to-serial circuit and no serial-to-parallel circuit in the physical layer of the memory controller. The memory chip has a memory I/O data bus coupled to a plurality of first bump groups, wherein the memory chip is coupled to the memory controller, there is no parallel-to-serial and no serial-to-parallel circuit in the memory chip. The memory controller and the memory chip are disposed on the substrate and horizontally space apart from each other.

According to one aspect of the invention, the plurality of first bump groups are arranged in side-by-side order, the plurality of second bump groups are arranged in side-by-side, each bump group of the plurality of first bump groups is connected to a corresponding bump group of the plurality of second bump groups through a corresponding track inside the substrate, and the tracks connected the plurality of first bump groups to the plurality of second bump groups do not cross each other.

Another embodiment of the present invention provides a memory chip. The memory chip includes a first set of memory banks and an I/O data bus of the memory chip. The I/O data bus of the memory chip is electrically coupled to the first set of memory banks, wherein each memory bank transmits a first predetermined width of data to the I/O data bus in parallel, a width of the I/O data bus is equal to a sum of the first predetermined width of data of each memory bank of the first set of the memory banks, and the first predetermined width is programmable according to a set of control signals. There is no parallel-to-serial and no serial-to-parallel circuit in the memory chip.

According to one aspect of the invention, the memory chip further includes a second set of memory banks, wherein each memory bank of the second set of memory banks transmits a second predetermined width of data to the I/O data bus in parallel, the width of the I/O data bus is selectively equal to, based on a selection signal, the sum of the first predetermined width of data of each memory bank of the first set of the memory banks or a sum of the second predetermined width of data of each memory bank of the second set of the memory banks.

According to one aspect of the invention, when the width of the I/O data bus is equal to the sum of the second predetermined width of data of each memory bank of the second set of the memory banks, the second predetermined width is programmable according to the set of control signals.

### Brief Description of the Drawings

The present invention is further illustrated by way of example, taking reference to the accompanying drawings thereof:
FIG. 1 is a diagram illustrating a memory system according to the prior art,
FIG. 2A, FIG. 2B are timing diagrams corresponding to the logic circuit writing the data into the memory,
FIG. 3 is a diagram illustrating a memory system according to a first embodiment of the present invention,
FIG. 4 is a diagram illustrating structures of two transceivers according to another embodiment of the present invention,
FIG. 5 is a timing diagram comparing a conventional memory system with the memory system,
FIG. 6 is a diagram illustrating an area of the memory being less than an area of the conventional memory and an area of the physical layer is also less than an area of a physical layer in the conventional logic circuit,
FIG. 7 is a diagram illustrating a data width of the memory being changed by control signals according to another embodiment of the present invention,
FIG. 8, FIG. 9 are diagrams illustrating different memories according to different embodiments of the present invention,
FIG. 10 is a diagram illustrating a chip being connected to a chip by using multi-layers configuration in a substrate according to another embodiment of the present invention,
FIG. 11 is a diagram illustrating via existing between two adjacent layer tracks and different layer tracks not crossing each other,
FIG. 12 and FIG. 13 are diagrams illustrating different layer tracks crossing each other,
FIG. 14 is a diagram illustrating a logic circuit and a DRAM, and a timing diagram of the DRAM corresponding to active read(R)/write(W) precharge command, R/W time, and a refresh command according to the prior art,
FIG. 15 is a diagram illustrating a pseudo SRAM controller and a pseudo SRAM, and a timing diagram of the pseudo SRAM corresponding to active R/W precharge command, R/W time, and a time trow according to the prior art,
FIG. 16 is a diagram illustrating a logic circuit and a DRAM, and a timing diagram of the DRAM corresponding to active R/W precharge command, R/W time, and a signal of an output pin according to one embodiment of the present invention, and
FIG. 17 is a diagram illustrating a pseudo SRAM controller and a pseudo SRAM, and a timing diagram of the pseudo SRAM corresponding to active R/W precharge command, R/W time, and a signal of an output pin according to one embodiment of the present invention.

### Detailed Description

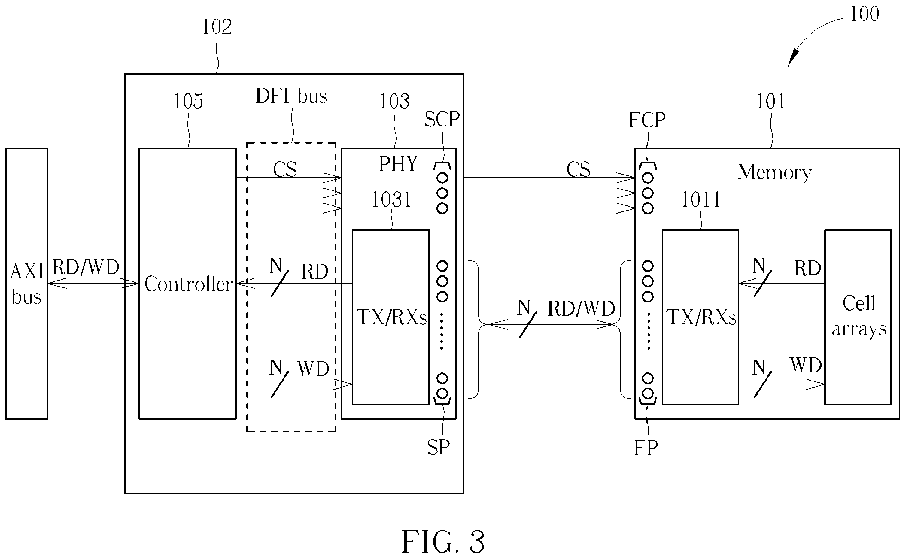

Please refer to FIG. 3. FIG. 3 is a diagram illustrating a memory system 100 according to a first embodiment of the present invention. As shown in FIG. 3, the memory system 100 includes a memory 101 and a logic circuit 102, wherein the memory 101 can be a dynamic random access memory (DRAM), a static random access memory (SRAM), a flash memory or other kinds of memories, and the logic circuit 102 can be an artificial intelligence (AI) chip or a system on chip (SOC). In addition, in one embodiment of the present invention, the memory 101 can include a base DRAM chip and a plurality of DRAM chips stacked above the base DRAM chip. In addition, the logic circuit 102 is coupled to other devices or processors through an AXI (Advanced eXtensible Interface) bus, wherein the AXI bus is a bus protocol, the protocol is part of the AMBA (Advanced Microcontroller Bus Architecture) 3.0 protocol. The AXI bus includes a writing data bus and a reading data bus. In addition, an operation method corresponding to the AXI bus is well-known to those of ordinary skill in the art, so further description thereof is omitted for simplicity.

The memory 101 includes a first align circuit 1011 and a plurality of first pads FP, wherein the first align circuit 1011 is used for aligning data corresponding to the memory 101, and includes a plurality of transceivers. That is, the first align circuit 1011 is used for simultaneously transmitting the data or simultaneously receiving the data (e.g. transmitting the data in a same clock or receiving the data in a same clock, that is, the plurality of transceivers of the first align circuit 1011 can transmit the data in parallel or receive the data in parallel). On the other hand, the logic circuit 102 includes a physical layer (PHY) 103 and a controller 105, wherein the physical layer 103 is electrically connected to the controller 105 through a Double Data Rate Physical Layer Interface (DDR PHY Interface, DFI) bus. The DFI bus includes a plurality of wire pairs, wherein the plurality of wire pairs include a plurality of writing wires and a plurality of reading wires. In addition, the physical layer 103 includes a second align circuit 1031 and a plurality of second pads SP, wherein the second align circuit 1031 is used for aligning the data, and also includes a plurality of transceivers. That is, the second align circuit 1031 is also used for simultaneously transmitting the data or simultaneously receiving the data (e.g. transmitting the data in a same clock or receiving the data in a same clock, that is, the plurality of transceivers of the second align circuit 1031 can transmit the data in parallel or receive the data in parallel).

In this embodiment of present invention, the first align circuit 1011 and the second align circuit 1031 can align and transmit the data in parallel, or can align and receive the data in parallel, and the data can be transmitted between the memory 101 and the logic circuit 102 without the conventional parallel-to-serial and serial-to-parallel circuits in both memory 101 and the physical layer 103. Therefore, the controller (or memory controller) 105 can utilize the plurality of wire pairs, the second align circuit 1031, the plurality of second pads SP, the plurality of first pads FP, and the first align circuit 1011 to access the data corresponding to the memory 101 in parallel. The number of the plurality of first pads FP can equal to a number of the plurality of writing wires (or a number of the plurality of reading wires) of the plurality of wire pairs of the DFI bus. Moreover, the number of the plurality of second pads SP can equal to a number of the plurality of writing wires (or a number of the plurality of reading wires) of the plurality of wire pairs of the DFI bus.

For example, as shown in FIG. 3, the number of the plurality of first pads FP or the number of the plurality of second pads SP equals N, and the data can be N-bit data RD read from cell arrays of the memory 101 or N-bit data WD written into the cell arrays of the memory 101. When the logic circuit 102 reads the N-bit data RD from the cell arrays of the memory 101 in parallel, the first align circuit 1011 receives the N-bit data RD from the cell arrays of the memory 101 in parallel and simultaneously transmits the N-bit data RD in parallel to the second align circuit 1031 through the plurality of first pads FP and the plurality of second pads SP. After the second align circuit 1031 receives the N-bit data RD in parallel, the second align circuit 1031 transmits the N-bit data RD to the controller 105 in parallel through the plurality of reading wires of the plurality of wire pairs of the DFI bus. On the other hand, when the logic circuit 102 writes the N-bit data WD into the cell arrays of the memory 101 in parallel, the second align circuit 1031 receives the N-bit data WD from the controller 105 in parallel through the plurality of writing wires of the plurality of wire pairs of the DFI bus. Then, the second align circuit 1031 simultaneously can transmit the N-bit data WD to the first align circuit 1011 in parallel not through conventional parallel-to-serial and serial-to-parallel circuits. After the first align circuit 1011 receives the N-bit data WD, the first align circuit 1011 writes the N-bit data WD into the cell arrays of the memory 101 in parallel.

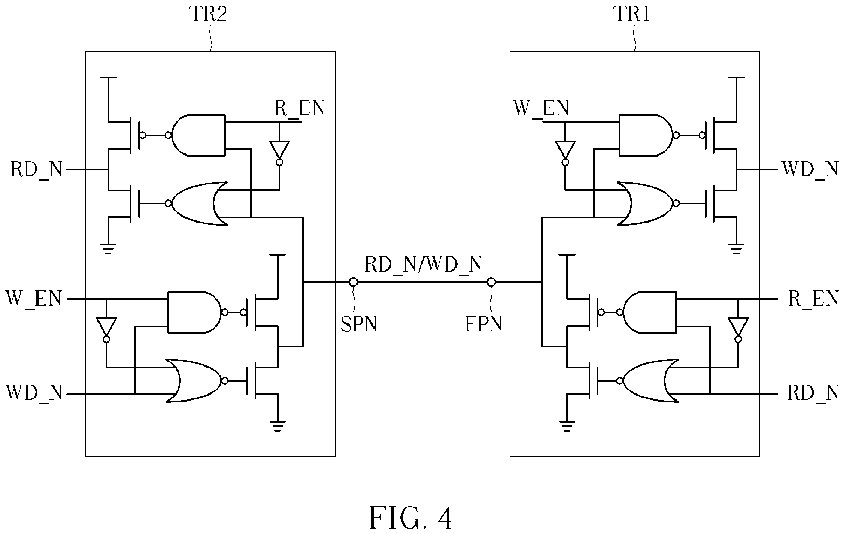

In addition, each of the first align circuit 1011 and the second align circuit 1031 comprises a plurality of transceivers, wherein each transceiver of the first align circuit 1011 is coupled to a corresponding pad of the plurality of first pads FP and each transceiver of the second align circuit 1031 is coupled to a corresponding pad of the plurality of second pads SP. Please refer to FIG. 4. FIG. 4 is a diagram illustrating structures of two transceivers TR1, TR2 according to another embodiment of the present invention, wherein each transceiver of the first align circuit 1011 (not shown in FIG. 4) can be the transceiver TR1, and each transceiver of the second align circuit 1031 (not shown in FIG. 4) can be the transceiver TR2. In addition, components of the transceivers TR1, TR2 are well-known to one of ordinary skill in the art, so further descriptions thereof are omitted for simplicity. In addition, coupling relationships between the components of the transceivers TR1, TR2 can be referred to FIG. 4, so further descriptions thereof are also omitted for simplicity. When a write enable signal W_EN is enabled and a read enable signal R_EN is disabled, the transceiver TR2 transmits a bit datum WD_N of the N-bit data WD to the transceiver TR1 through a first pad FPN and a second pad SPN. On the other hand, when the write enable signal W_EN is disabled and the read enable signal R_EN is enabled, the transceiver TR1 transmits a bit datum RD_N of the N-bit data RD to the transceiver TR2 through the first pad FPN and the second pad SPN. Because the write enable signal W_EN and the read enable signal R_EN are common signals for the first align circuit 1011 and the second align circuit 1031, the first align circuit 1011 can simultaneously transmit the N-bit data RD in parallel or receive the N-bit data WD in parallel, and the second align circuit 1031 can simultaneously transmit the N-bit data WD in parallel or receive the N-bit data RD in parallel.

In another embodiment of the present invention, a first write enable signal and a first read enable signal are signals for the first align circuit 1011, and a second write enable signal and a second read enable signal are signals for the second align circuit 1031, wherein the first write enable signal and the first read enable signal correspond to the second write enable signal and the second read enable signal, respectively.

Because the first align circuit 1011 and the second align circuit 1031 can transmit data in parallel or receive data in parallel not through conventional parallel-to-serial and serial-to-parallel circuits, the first align circuit 1011 can simultaneously transmit the N-bit data RD to the second align circuit 1031 in parallel or receive the N-bit data WD from the second align circuit 1031 in parallel, and similarly, the second align circuit 1031 can simultaneously receive the N-bit data RD from the first align circuit 1011 in parallel or transmit the N-bit data WD to the first align circuit 1011 in parallel. In addition, as shown in FIG. 4, the present invention is not limited to each transceiver of the first align circuit 1011 being the transceiver TR1 and each transceiver of the second align circuit 1031 being the transceiver TR2. That is, each transceiver of the first align circuit 1011 and each transceiver of the second align circuit 1031 can be other transmitting/receiving circuits, buffers or registers.

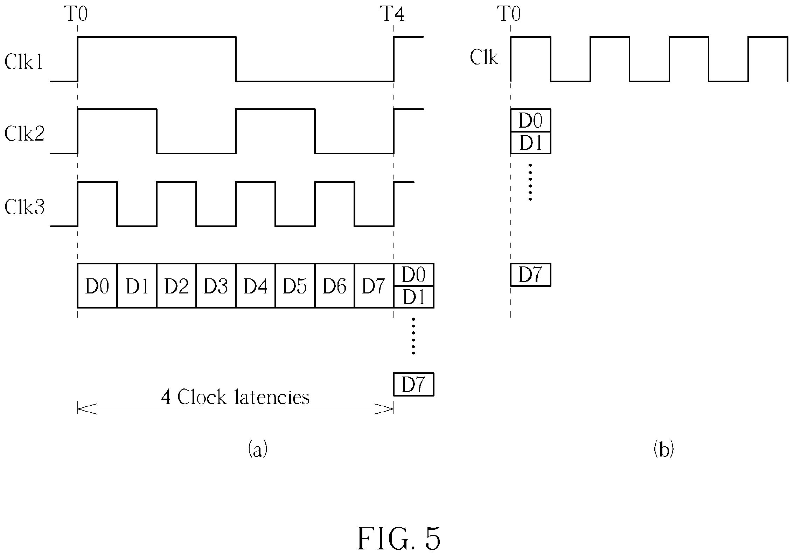

Please refer to FIG. 5. FIG. 5 is a timing diagram for comparing a conventional memory system with the memory system 100. For example, as shown in FIG. 5(a), when a conventional logic circuit reads 8-bit data D0-D7 from a conventional memory, the conventional memory needs to utilize three clocks clk1, clk2, clk3 to form 8 statuses, such that the 8-bit data D0-D7 can be transmitted in serial (for example, datum D0 corresponds to status (clk1=1, clk2= 1, clk3=1), datum D1 corresponds to status (clk1=1, clk2=1, clk3=0) ... and so on). Therefore, a controller of the conventional logic circuit can only start to receive the data D0-D7 until a time T4 in parallel. However, as shown in FIG. 5(b), because the data D0-D7 are transmitted simultaneously by the memory 101, the controller 105 can start to receive the data D0-D7 at a time T0. Therefore, compared to the conventional memory system, the present invention can save 4 clock latencies. In addition, operation method of writing the 8-bit data D0-D7 is similar to the above-mentioned operation methods, so further descriptions thereof are omitted for simplicity.

Please refer to FIG. 3 again. As shown in FIG. 3, the controller 105 is further coupled to the physical layer 103 through a plurality of control wires, the physical layer 103 further includes a plurality of second control pads SCP, the memory 101 further includes a plurality of first control pads FCP, and the plurality of first control pads FCP are electrically connected to the plurality of second control pads SCP. Therefore, the controller 105 can utilize the plurality of control wires, the plurality of second control pads SCP, and the plurality of first control pads FCP to transmit control signals CS to the memory 101. In addition, FIG. 3 only shows three first control pads, three second control pads, and three control wires, but the present invention is not limited thereto. In addition, the plurality of control wires and the plurality of wire pairs between the physical layer 103 and the controller 105 are included in the DFI bus, wherein the DFI bus defines signals, timing parameters, and programmable parameters required for communications between the physical layer 103 and the controller 105. Therefore, the control signals CS are defined by the DFI bus and can include, for example, write enable signal, read enable signal, and chip select signal. In addition, an operation method corresponding to the DFI bus is well-known to those of ordinary skill in the art, so further description thereof is omitted for simplicity. In addition, the logic circuit 102 in another embodiment may further includes system circuits (not shown in FIG. 3), wherein the system circuits can include other peripheral interfaces. The controller or memory controller 105 communicates with the system circuits through an Advanced eXtensible Interface (AXI) bus. For example, the controller 105 can transmit the N-bit data RD to the system circuits or receive the N-bit data WD from the system circuits through the AXI bus to other devices or processors.

In addition, the plurality of first pads FP can be electrically connected to the plurality of second pads SP by metal wires, metal bridges, flip-chip, micro-bump, or other bonding technologies. In addition, in another embodiment of the present invention, because the plurality of first pads FP are electrically connected to the plurality of second pads SP, the plurality of first pads FP and the plurality of second pads SP are not coupled to environment outside the memory system 100. Therefore, the plurality of first pads FP and the plurality of second pads SP do not need to include conventional electrostatic discharge (ESD) protection circuits, and sizes of the plurality of first pads FP and the plurality of second pads SP can be reduced.

In another embodiment of the present invention, the second align circuit 1031 of the physical layer 103 can be applied to different data width which is depending on a data width of the AXI bus. However, in another embodiment of the present invention, both the second align circuit 1031 of the physical layer 103 and the first align circuit 1011 of the memory 101 can be applied simultaneously to different data width which depends on the data width of the AXI bus. For example, when the logic circuit 102 is applied to a memory with Q-bit data width, the controller 105 can inform the physical layer 103 to adjust the second align circuit 1031 to make the second align circuit 1031 only utilize Q reading wires of the plurality of wire pairs to transmit Q-bit data to the controller 105 (or utilize Q writing wires of the plurality of wire pairs to receive Q-bit data from the controller 105), wherein Q is a positive integer greater than 1 and less than N. Therefore, the physical layer 103 and the controller 105 can be applied to different system circuits and different memories with the different data width.

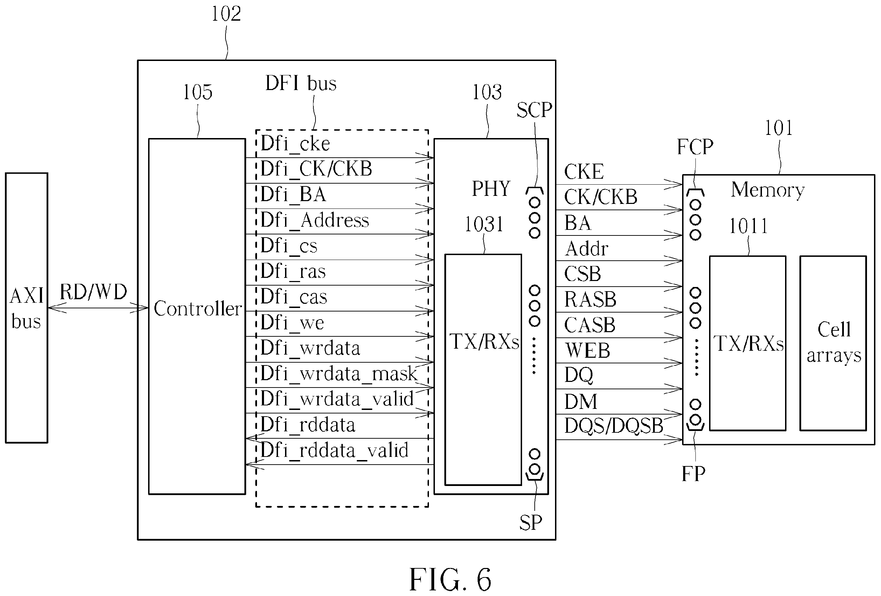

Because the first align circuit 1011 and the second align circuit 1031 are smaller and simpler, and the conventional parallel-to-serial and serial-to-parallel circuits are omitted from the memory 101 and the physical layer 103, reading/writing speed of the memory 101 are significantly increased, an area of the memory 101 is less than an area of the conventional memory and an area of the physical layer 103 is also is less than an area of a physical layer in the conventional logic circuit (as shown in FIG. 6), and a memory-wall problem between the memory 101 and the logic circuit 102 can be reduced. In addition, the physical layer 103 can receive signals of Dfi cke, Dfi CK/CKB, Dfi BA, Dfi address, Dfi cs, Dfi_ras, Dfi cas, Dfi we, Dfi wrdata, Dfi wrdata mask, Dfi wrdata valid from the controller 105 and transmit signals of Dfi rddata, Dfi rddata valid to the controller 105 through the DFI bus, wherein the signals of Dfi cke, Dfi CK/CKB, Dfi BA, Dfi address, Dfi cs, Dfi_ras, Dfi cas, Dfi we, Dfi wrdata, Dfi wrdata mask, Dfi wrdata valid and the signals of Dfi rddata, Dfi rddata valid are well-defined in DFI specification, so further descriptions thereof are omitted for simplicity. In addition, the physical layer 103 can transmit signals of CKE, CK/CKB, BA, Addr, CSB, RASB, CASB, WEB, DQ, DM, DQS/DQSB to the memory 101, wherein the signals of CKE, CK/CKB, BA, Addr, CSB, RASB, CASB, WEB, DQ, DM, DQS/DQSB are also well-defined in DFI specification, so further descriptions thereof are omitted for simplicity. Therefore, the plurality of first pads FP can be electrically connected to the plurality of second pads SP even if the memory 101 and the logic circuit 102 are made by heterogeneous processes. For example, transistors of the memory 101 can be planar or trench transistors adopted by current memory technologies (e.g. DRAM or HBM technologies) while transistors of the logic circuits 102 can be 3D transistors (e.g. tri-gate transistors, fin field-effect transistors (FinFETs), or gate-all-around transistors). However, in another embodiment of the present invention, the memory 101 and the logic circuit 102 are made by homogeneous processes. That is, the memory 101 and the logic circuit 102 can adopt the planar or trench transistors, the tri-gate transistors, the FinFETs, gate-all-around transistors, or other transistors. Moreover, powers of the memory 101 and the logic circuits 102 are saved, latencies of accessing the memory 101 are reduced, and cost of areas of the memory 101 and the logic circuits 102 are decreased by adopting the first align circuit 1011 and the second align circuit 1031, rather than adopting the conventional parallel-to-serial and serial-to-parallel circuits. Therefore, reading/writing window margins of the memory system 100 are improved.

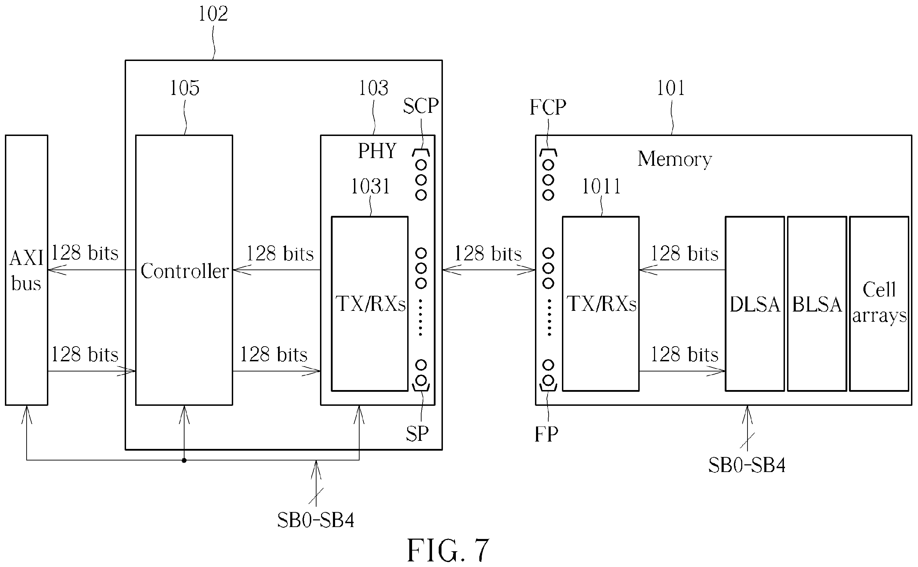

In addition, please refer to FIG. 7. FIG. 7 is a diagram illustrating a data width of the memory being changed by control signals according to another embodiment of the present invention. For example (but not limited), the memory 101 includes M second sensing amplifiers BLSA (i.e. bit line sensing amplifiers) and N first sensing amplifiers DLSA (i.e. data line sensing amplifiers), wherein a connected number of the M second sensing amplifiers BLSA electrically coupled to the first sensing amplifiers DLSA can be changed by control signals ( such as SB0-SB4 according to TABLE 1), the second sensing amplifiers BLSA are between the cell arrays and the first sensing amplifiers DLSA, the first sensing amplifiers are between the second sensing amplifiers BLSA and the first align circuit 1011 which includes the plurality of transceivers, the first align circuit 1011 is between the first sensing amplifiers DLSA and an I/O data bus (not shown in FIG. 7) of the memory 101, N is a positive integer and not greater than M, and the I/O data bus is coupled to the plurality of first pads FP.

In one embodiment, the control signals are stored in a register (not shown in FIG. 7) of the memory 101, such as mode registers. In addition, the second sensing amplifiers BLSA are connected to bit lines (not shown in FIG. 7) of the memory 101, and the first sensing amplifiers DLSA are connected to data lines (not shown in FIG. 7) of the memory 101. The N first sensing amplifiers DLSA are electrically coupled to part of the M second sensing amplifiers BLSA through a plurality of bit switches, and those bit switches could be selected or activated by the aforesaid control signals.

As shown in TABLE 1 and FIG. 7, when the control signals SB0-SB4 are 0/0/0/0/1, 128 second sensing amplifiers are electrically coupled to 128 first sensing amplifiers through bit switches (not shown in FIG. 7, a group of selected bit switches, such as 128 or less bit switches based on ONE given column address, are selected by the control signals SB0-SB4 (0/0/0/0/1)), 128 bits data can be read from the cell arrays of the memory 101 through part of the second sensing amplifiers and the first sensing amplifiers (such as through the 128 connected second sensing amplifiers and the 128 first sensing amplifiers), or written into the cell arrays of the memory 101 by the first align circuit 1011 through part of the second sensing amplifiers and the first sensing amplifiers (such as through the 128 connected second sensing amplifiers and the 128 first sensing amplifiers). That is, when the 128 bits data are read from the cell arrays of the memory 101, the plurality of transceivers of the first align circuit 1011 parallelly receive and transmit the 128 bits data from the 128 first sensing amplifiers to the I/O data bus of the memory 101, or when the 128 bits data are written into the cell arrays of the memory 101, the plurality of transceivers of the first align circuit 1011 parallelly receive and transmit the 128 bits data from the I/O data bus to the 128 first sensing amplifiers. Or in other words, when the 128 bits data are read from the cell arrays of the memory 101, part of the second sensing amplifiers BLSA (such as the 128 connected second sensing amplifiers) output the 128 bits data to the first sensing amplifiers DLSA (such as the 128 first sensing amplifiers) which then parallelly output the 128 bits data to the plurality of transceivers, or when the 128 bits data are written into the cell arrays of the memory 101, the 128 first sensing amplifiers parallelly output the 128 bits data to part of the connected second plurality of sensing amplifiers (such as the 128 second sensing amplifiers BLSA). In addition, a data width of the memory 101 (i.e. a width of the I/O data bus of the memory 101) is equal to 128 according to the 128 first sensing amplifiers. Meanwhile, because the data width of the memory 101 is equal to 128, both a data width of the controller 105 and the data width of the AXI bus are equal to 128.

In another embodiment of the present invention, a read (or write) data width of the DFI bus coupled to physical layer 103 are also equal or set to 128 according to the control signals SB0-SB4. In addition, as shown in FIG. 7, when the logic circuit 102 is included in a computing system with a system bus interface (i.e. the AXI bus) which includes a read data bus and a write data bus, both a width of the read data bus and a width of the write data bus are equal to 128 according to the control signals SB0-SB4 (0/0/0/0/1) inputted to the controller 105. In addition, a width of the DFI bus is selectively adjusted according to the control signals SB0-SB4 (0/0/0/0/1) inputted to the physical layer 103.

Similarly, as shown in TABLE 1 and FIG. 7, when the control signals SB0-SB4 are 0/0/0/1/0, 256 second sensing amplifiers of the M second sensing amplifiers are electrically coupled to 256 first sensing amplifiers through another group of selected bit switches (such as 256 or less bit switches based on ONE given column address), so the data width of the memory 101 is limited to be equal to 256 according to the 256 first sensing amplifiers; when the control signals SB0-SB4 are 0/0/0/1/1, 512 second sensing amplifiers of the M second sensing amplifiers are electrically coupled to 512 first sensing amplifiers through other selected bit switches (such as 512 or less bit switches based on ONE given column address), so the data width of the memory 101 is limited to be equal to 512 according to the 512 first sensing amplifiers; when the control signals SB0-SB4 are 0/0/1/0/0, 1024 second sensing amplifiers of the M second sensing amplifiers are electrically coupled to 1024 first sensing amplifiers through other selected bit switches (such as 1024 or less bit switches based on ONE given column address), so the data width of the memory 101 is limited to be equal to 1024 according to the 1024 first sensing amplifiers; and when the control signals SB0-SB4 are 0/0/0/0/0, 64 second sensing amplifiers of the M second sensing amplifiers are electrically coupled to 64 first sensing amplifiers through selected bit switches (such as 64 or less bit switches based on ONE given column address), so the data width of the memory 101 is limited to be equal to 64 according to the 64 first sensing amplifiers. In addition, the present invention is not limited to the memory 101 including the M second sensing amplifiers and configurations of the control signals SB0-SB4 shown in FIG. 7. In addition, the present invention is also not limited to a number of the control signals SB0-SB4, that is, the present invention can have a number of control signals less than or more than the number of the control signals SB0-SB4.

**TABLE 1**

| SB4/SB3/SB2/SB1/SB0 | The data width of the memory 101 | The data width of the controller 105 | The data width of the AXI bus |
|---|---|---|---|
| 0/0/1/0/0 | 1024 | 1024 | 1024 |
| 0/0/0/1/1 | 512 | 512 | 512 |
| 0/0/0/1/0 | 256 | 256 | 256 |
| 0/0/0/0/1 | 128 | 128 | 128 |
| 0/0/0/0/0 | 64 | 64 | 64 |

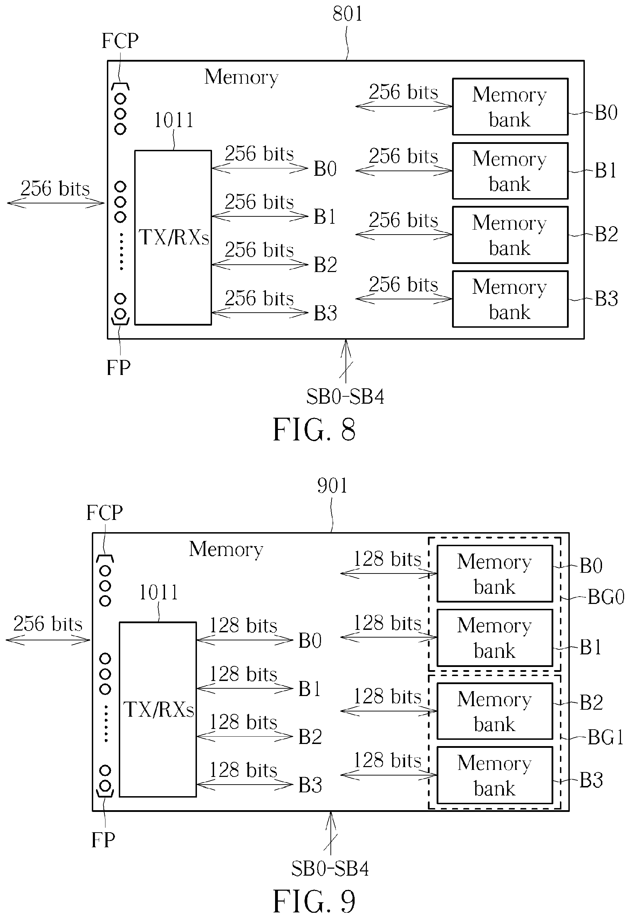

In addition, please refer to FIG. 8. FIG. 8 is a diagram illustrating a memory 801 according to another embodiment of the present invention, wherein a difference between the memory 801 and the memory 101 is that the memory 801 includes 4 memory banks B0-B3, each memory bank of the memory banks B0-B3 is just the cell arrays of the memory 101. But, the present invention is not limited to the memory 801 including the 4 memory banks B0-B3 (that is, the memory 801 can include a plurality of memory banks). In addition, for simplicity, the M second sensing amplifiers BLSA and the N first sensing amplifiers DLSA are not shown in FIG. 8.

As shown in TABLE 2 and FIG. 8, when the control signals SB0-SB4 are 0/0/0/1/0, 256 second sensing amplifiers of a specific memory bank of the memory 801 could be electrically coupled to 256 first sensing amplifiers by the control signals SB0-SB4, so 256 bits data can be read from the specific memory bank of the memory 801 by the first align circuit 1011 through the 256 connected second sensing amplifiers and the 256 first sensing amplifiers, or written into the specific memory bank of the memory 801 by the first align circuit 1011 through the 256 connected second sensing amplifiers and the 256 first sensing amplifiers. The specific memory bank of the memory 801 could be selected by another signal, such as bank selected signals. That is, as shown in TABLE 2, a data width of the selected memory bank of the memory 801 could be adjusted to be equal to 256 according to the 256 first sensing amplifiers. In addition, because the 4 memory banks B0-B3 are independent of each other, a data width of the memory 801 (i.e. a width of the I/O data bus of the memory 801) is also equal to 256. In addition, in another embodiment both the data width of the controller 105 and the data width of the DFI bus are equal to 256 according to the control signals SB0-SB4 (0/0/0/1/0)

In addition, other data widths of the each memory bank of the memory 801 and other data widths of the memory 801 corresponding to the control signals SB0-SB4 (0/0/1/0/0), (0/0/0/1/1), (0/0/0/0/1), (0/0/0/0/0) can be referred to TABLE 2, so further descriptions thereof are omitted for simplicity. In addition, the present invention is not limited to configurations of the control signals SB0-SB4 shown in FIG. 8.

**TABLE 2**

| SB4/SB3/SB2/SB1/SB0 | The data width of the AXI bus | The data width of the each memory bank | The data width of the memory 801 |
|---|---|---|---|
| 0/0/1/0/0 | 1024 | 1024 | 1024 |
| 0/0/0/1/1 | 512 | 512 | 512 |
| 0/0/0/1/0 | 256 | 256 | 256 |
| 0/0/0/0/1 | 128 | 128 | 128 |
| 0/0/0/0/0 | 64 | 64 | 64 |

In addition, please refer to FIG. 9. FIG. 9 is a diagram illustrating a memory 901 according to another embodiment of the present invention, wherein a difference between the memory 901 and the memory 801 is that the memory banks B0, B1 are included in a bank group BG0, and the memory banks B2, B3 are included in a bank group BG1. But, the present invention is not limited to the bank group BG0 including the memory banks B0, B1, and the bank group BG1 including the memory banks B2, B3. For example, all banks B0, B1, B2, B3 could be grouped as a bank group BGX.

Taking the bank group BG0 as an example, a first set of sensing amplifiers coupled to the data lines and a second set of sensing amplifiers coupled to the data lines, wherein the first set of sensing amplifiers corresponds to the memory bank B0 and is configured to parallelly output a first plurality of data, the second set of sensing amplifiers corresponds to the memory bank B1 and configured to parallelly output a second plurality of data, and the first set of sensing amplifiers and the second set of sensing amplifiers are just the previously mentioned first sensing amplifiers (that is, DLSA). In addition, a third set of sensing amplifiers is coupled to the bit lines and configured between the memory bank B0 and the first set of sensing amplifiers, and a fourth set of sensing amplifiers is coupled to the bit lines and configured between the memory bank B1 and the second set of sensing amplifiers, wherein the third set of sensing amplifiers and the fourth set of sensing amplifiers are just the previously mentioned second sensing amplifiers (that is, BLSA).

Therefore, as shown in TABLE 3 and FIG. 9, when the control signals SB0-SB4 are 0/1/0/1/0, 128 second sensing amplifiers corresponding to each memory bank of a specific bank group (e.g. the bank group BG0) are electrically coupled to 128 first sensing amplifiers corresponding to the each memory bank of the specific bank group by the control signals SB0-SB4, so 256 bits data can be read from the specific bank group by the first align circuit 1011 through 256 connected second sensing amplifiers and 256 first sensing amplifiers (because the first align circuit 1011 can read 128 bits data of the 256 bits data from one memory bank of the specific bank group through 128 connected second sensing amplifiers and 128 first sensing amplifiers corresponding to the one memory bank, and read other 128 bits data of the 256 bits data from another memory bank of the specific bank group through other 128 connected second sensing amplifiers and other 128 first sensing amplifiers corresponding to the another memory bank), or the 256 bits data can be written into the specific bank group by the first align circuit 1011 through the 256 connected second sensing amplifiers and the 256 first sensing amplifiers (because the first align circuit 1011 can write the 128 bits data of the 256 bits data to the one memory bank of the specific bank group through the 128 connected second sensing amplifiers and the 128 first sensing amplifiers corresponding to the one memory bank, and write the other 128 bits data of the 256 bits data to the another memory bank of the specific bank group through the other 128 connected second sensing amplifiers and the other 128 first sensing amplifiers corresponding to the another memory bank). That is, as shown in TABLE 3, a data width of each memory bank of the specific bank group are limited to be equal to 128 according to the 128 first sensing amplifiers. In addition, because the memory banks B0, B1 are included in the bank group BG0, a data width of the memory 901 (i.e. a width of the I/O data bus of the memory 901) is equal to a sum (i.e. 128+128=256) of data width of all memory banks of the specific bank group. And the available banks will be reduced to half, as compared to Fig. 8.

In addition, other data widths of the each memory bank of the memory 901 and other data widths of the memory 901 corresponding to the control signals SB0-SB4(0/1/0/0/0), (0/1/0/0/1), (0/1/0/1/1), (0/0/0/0/0) can be referred to TABLE 3, so further descriptions thereof are omitted for simplicity. In addition, the present invention is not limited to configurations of the control signals SB0-SB4 shown in FIG. 9.

**TABLE 3**

| SB4/SB3/SB2/SB1/SB0 | The data width of the AXI bus | The data width of the memory 901 | The data width of the each memory |
|---|---|---|---|
| | | | bank |
| 0/1/0/0/0 | 1024 | 1024 | 512 |
| 0/1/0/0/1 | 512 | 512 | 256 |
| 0/1/0/1/0 | 256 | 256 | 128 |
| 0/1/0/1/1 | 128 | 128 | 64 |
| 0/0/0/0/0 | 64 | 64 | 32 |

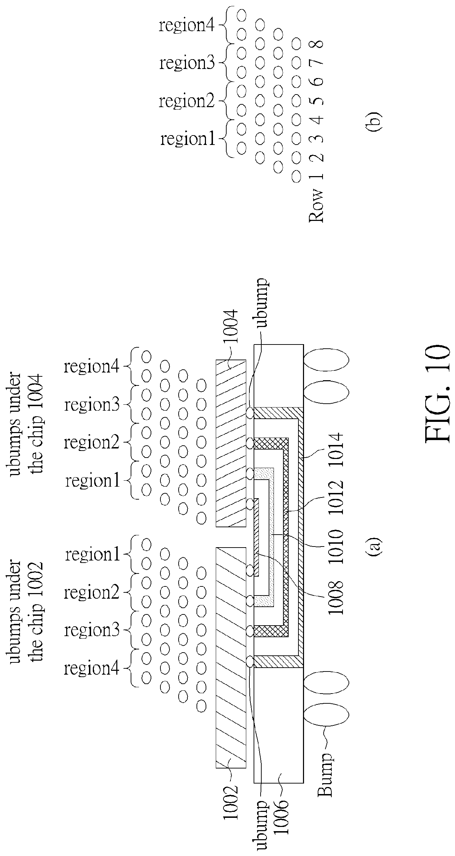

Next, please refer to FIG. 10. FIG. 10 is a diagram illustrating a chip 1002 being connected to a chip 1004 by using multi-layers configuration in a substrate 1006 according to another embodiment of the present invention, wherein the chip 1002 can be referred to the logic circuit 102 in FIG. 7, the chip 1004 can be also referred to the memory 101 in FIG. 7, and the chip 1002 and the chip 1004 have micro-bumps (uBumps) or any type of pillars (such as copper pillars) at bottoms thereof. As shown in FIG. 10(a), due to the larger width of data input/output bus of the memory or the larger number of the uBumps or pillars, when layer1 tracks 1008 in the substrate 1006 are not enough for all connections between the chip 1002 and the chip 1004 because the substrate 1006 is tiny, meanwhile, for example, layer2 tracks 1010, layer3 tracks 1012, and layer4 tracks 1014 in the substrate 1006 are additionally provided to complete all connections between the chip 1002 and the chip 1004, wherein the layer1 tracks 1008, the layer2 tracks 1010, the layer3 tracks 1012, and the layer4 tracks 1014 are located at different depths in the substrate 1006. In addition, the present invention is not limited to the layer1 tracks 1008, the layer2 tracks 1010, layer3 tracks 1012, and layer4 tracks 1014 being used for completing all connections between the chip 1002 and the chip 1004, that is, the present invention can use more than 2 layer tracks to complete all connections between the chip 1002 and the chip 1004. In addition, uBumps or pillars under the chip 1002 can be assigned into a plurality of regions (for example, region1, region2, region3, region4) depending on the number of the uBumps (or pillars) and the size of the substrate 106, wherein those uBumps at the region1 are 1st closest to the chip 1004, those uBumps at the region1 will use the layer1 tracks to complete the connections between the chip 1002 and the chip 1004, and as shown in FIG. 10(b), the uBumps at the region1 can be assigned in row1, row 2 (or more than two rows). Similarly, those uBumps at the region2 are 2nd closest to the chip 1004, those uBumps at the region2 will use the layer2 tracks to complete the connections between the chip 1002 and the chip 1004, and as shown in FIG. 10(b), those uBumps at the region2 can be assigned in row3, row 4 (or more than two rows). In addition, configuration of uBumps at the region3 and configuration of uBumps at the region4 can be referred to the aforesaid configurations for uBumps at the region1 or region2, so further description thereof is omitted for simplicity. Similarly, as shown in FIG. 10(a), 10(b), uBumps under the chip 1004 can be also assigned into a plurality of regions (for example, region1, region2, region3, region4) depending on the size of the substrate 106, and configuration of uBumps under the chip 1004 can be referred to configuration of uBumps under the chip 1002, so further description thereof is also omitted for simplicity.

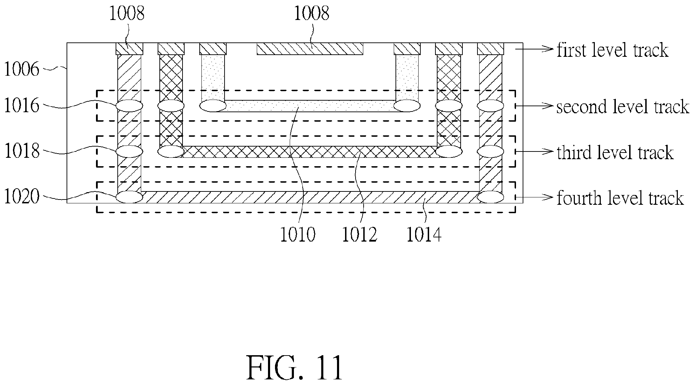

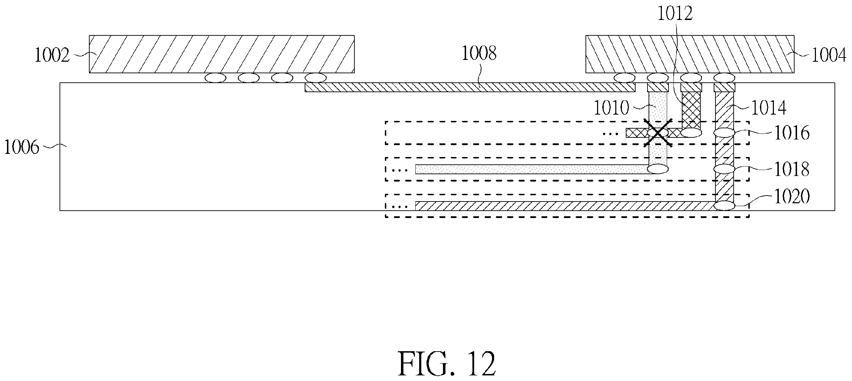

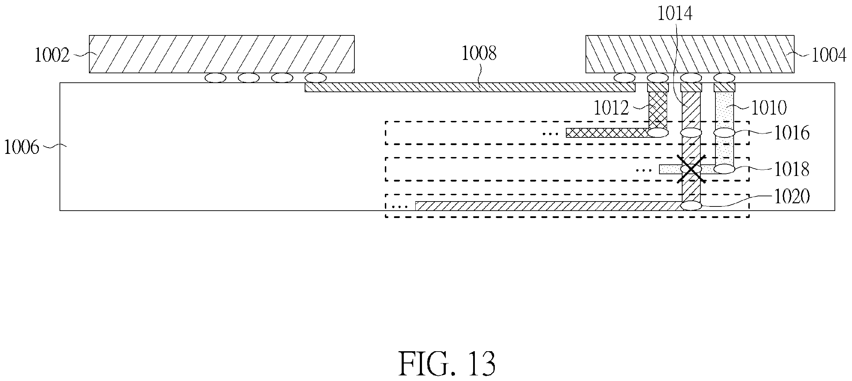

In addition, as shown in FIG. 11, via 1016 connects the second level track (such as the layer2 tracks 1010, upward extending portion of the layer3 tracks 1012 in the second level track, and/or upward extending portion of the layer4 tracks 1014 in the second level track) to the first level track (such as layer1 tracks 1008), and via 1018 connects the third level track (such as the layer2 tracks 1010, and/or upward extending portion of the layer4 tracks 1014 in the third level track) to the second level track, and via 1020 connects the fourth level track (such as layer3 tracks 1012) to the third level track. The locations of upward extending portion of the layer3 tracks 1012 are outside the locations of upward extending portion of the layer2 tracks 1010. Otherwise, as shown in FIG. 12, in the event the layer3 tracks 1012, rather than the layer2 tracks 1010, is used for connecting some uBumps in region2, the layer2 tracks 1010 which is gone through by the mentioned layer3 tracks 1012 may fail for utilization (shown in cross sign of FIG. 12), so that number of available tracks of the layer2 tracks 1010 is reduced. Similarly, the locations of upward extending portion of the layer4 tracks 1014 are outside the locations of upward extending portion of the layer3 tracks 1012. Otherwise, as shown in FIG. 13, the layer3 tracks 1012 which is gone through by the mentioned layer4 tracks 1014 may fail for utilization (shown in cross sign of FIG. 13), so that number of available tracks of the layer3 tracks 1012 is reduced.

Next, the present invention will show (not limited to) example parameters of two designed embodiments, wherein the design embodiment 1 uses 4 layer tracks (the layer1 tracks, the layer2 tracks, the layer3 tracks, the layer4 tracks) and the design embodiment 2 uses 9 layer tracks (the layer1 tracks, the layer2 tracks, the layer3 tracks, the layer4 tracks, the layer5 tracks, the layer6 tracks, the layer7 tracks, the layer8 tracks, the layer9 tracks).

### The designed embodiment 1

TABLE 4 shows parameters of the designed embodiment 1, wherein "ubump pitch1" corresponds to the pitch of ubump in region1, "line pitch1" corresponds to the pitch of the layer1 tracks. The "ubump pitch2" corresponds to the pitch of ubump in region2, region3, and region4. The "line pitch2" corresponds to the pitch of the layer2 tracks, the layer3 tracks and the layer4 tracks. The pitch for via connecting the first level track and the second level track is represented as "via12 pitch", the "via23 pitch" represents the pitch of via connecting the second level track and the third level track, and the "via34 pitch" represents the pitch of via connecting the third level track and the fourth level track:

**TABLE 4**

| | Width (um) |
|---|---|
| ubump pitch1 | 85+8 |
| line pitch1 | 6+8 |
| via12 pitch | 85+8 |
| ubump pitch2 | 85+12 |
| line pitch2 | 12+12 |
| via23 pitch (via34 pitch) | 85+12 |

TABLE 5 is shown as follows, wherein the designed embodiment 1 has 407 ubumps, via pitch corresponding to the layer1 tracks and the layer2 tracks means via12 pitch, via pitch corresponding to the layer3 tracks means via23 pitch, and via pitch corresponding to the layer4 tracks means via34 pitch:

**TABLE 5**

| | the layer1 tracks | the layer2 tracks | the layer3 tracks | the layer4 tracks |
|---|---|---|---|---|
| ubump pitch (um) | 85+8 (inregion1) | 85+12 (region2) | 85+12 (region3) | 85+12 (region4) |
| via pitch (um) | | 85+8 (via12) | 85+12 (via23) | 85+12 (via34) |
| line pitch (um) | 6+8 | 12+12 | 12+12 | 12+12 |
| number of lines | 119 | 96 | 96 | 96 |

### The designed embodiment 2

TABLE 6 shows parameters of the designed embodiment 2 with 9 layer tracks in the substrate and 400 ubumps. In addition, number of lines of each layer tracks of the layer1~8 tracks is 46 and number of lines of the layer9 tracks is 32. TABLE 6 is shown as follows, wherein "ubump pitch" corresponds to the pitch of ubump in region1~region9, "line pitch" corresponds to the pitch of layer1~9 tracks, and "via pitch" corresponds to the pitch of via12, via23, via34, via45, via56, via67, via78, via89 (wherein via12 connects the first level track and the second level track, via23 connects the second level track and the third level track, via34 connects the third level track and the fourth level track, via45 connects the fourth level track and the fifth level track, via56 connects the fifth level track and the sixth level track, via67 connects the sixth level track and the seventh level track, via78 connects the seventh level track and the eighth level track, via89 connects the eighth level track and the ninth level track):

**TABLE 6**

| | Width (um) |
|---|---|
| ubump pitch | 85+25 |
| line pitch | 25+25 |
| via pitch | 85+25 |

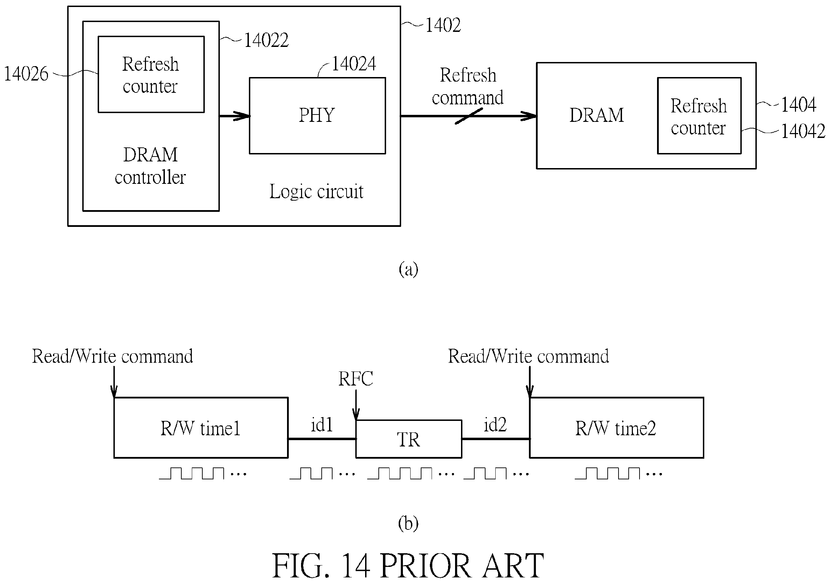

Furthermore, the present invention also improve the refresh scheme of the conventional memory. Please refer to FIG. 14 of the conventional DRAM and its controller. FIG. 14(a) is a diagram illustrating a logic circuit 1402 and a DRAM (e.g. DDR3-DDR5 or low power DDR3~DDR5) 1404, and FIG. 14(b) is a timing diagram of the DRAM 1404 corresponding to an access command or a Read(R)/Write(W) command (for simplicity purpose, it includes active command- read/write command- precharge command), read(R)/write(W) time1, a refresh command RFC, another R/W time2 according to the prior art. As shown in FIG. 14(a), a refresh counter 14026 inside a DRAM controller 14022 of the logic circuit 1402 counts DRAM refresh interval tREFI according to number of clocks(clks), and issues the auto refresh command RFC when the number of clocks(clks) reaches a target according to a DRAM specification, wherein the auto refresh command RFC is transmitted to the DRAM 1404 through a PHY 14024. For example, tREFI=4us means every 4K clks(4us) or tREFI=8us means every 8K clks(8us), when 1 clk=1ns.

In addition, as shown in FIG. 14(a), a refresh counter 14042 inside the DRAM 1404 sends next word line address needing to execute refresh while receiving the auto refresh command RFC. When the self refresh command is issued, the refresh counter 14042 also need to count the DRAM refresh interval tREFI according to number of clks, and issue internal refresh when the number of clks reaches the target according to the DRAM specification. For example, tREFI=4us means every 4K clks(4us) or tREFI=8us means every 8K clks(8us) when 1 clk=1ns.

The refresh counter 14042 counts WL address in auto refresh mode or self refresh modes. The refresh counter 14042 further counts DRAM refresh interval in self refresh mode. On the other hand, the refresh counter 14026 inside a DRAM controller 14022 will not counts WL address in auto refresh mode or self refresh mode. However, the refresh counter 14026 inside the DRAM controller 14022 could count DRAM refresh interval in auto Refresh mode.

In addition, as shown in FIG. 14(b) of the conventional DRAM timing diagram, after issuing Read(R)/Write(W) command, R/W time1 is required which is the time for reading/writing from/to the DRAM 1404. Afterward, an idle time id1 exists between R/W time1 and the refresh command RFC, then a time tRFC is time for refresh after receiving refresh command, and then a next idle time id2 exists between the time tRFC and a next Read(R)/Write(W) command. For further reading from or writing to DRAM, R/W time2 is required as well. Thus, there are interval period (id1+tRFC+id2) between R/W time1 and R/W time2.

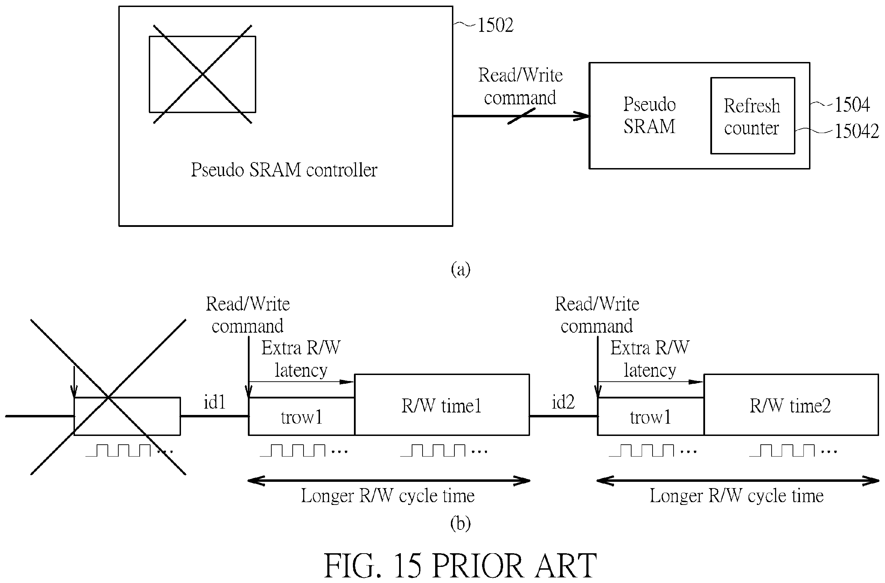

Next, please refer to FIG. 15 of the conventional pseudo SRAM and its controller. FIG. 15(a) is a diagram illustrating a pseudo SRAM controller 1502 and a pseudo SRAM 1504, and FIG. 15(b) is a timing diagram of the pseudo SRAM 1504 corresponding to Read(R)/Write(W) command (for simplicity, it also includes active command- read/write command- precharge command), a time trow1, R/W time1, another Read(R)/Write(W) command, another time trow1, and another R/W time2 according to the prior art. As shown in FIG. 15(a), it is noted that a difference between the DRAM controller 14022 and the pseudo SRAM controller 1502 is that there is no a refresh counter inside the pseudo SRAM controller 1502, so that the pseudo SRAM controller 1502 does not need to issue any refresh commands to the pseudo SRAM 1504. When the power is ON, a refresh counter 15042 inside the pseudo SRAM 1504 will start counting and sending internal refresh command plus next word line address needing to execute refresh internally to avoid any memory cell failed inside the pseudo SRAM 1504. As shown in FIG. 15(b), when receiving Read(R)/Write(W) command from the pseudo SRAM controller 1502, however, the pseudo SRAM 1504 needs to wait the time trow1 assuming refresh just occurred before executing the Read/Write command, and therefore it will cause extra Read/Write latency and longer Read/Write cycle time. Wherein an idle time id exists before receiving next Read(R)/Write(W) command from the pseudo SRAM controller 1502, and the another time trow1 is also required before executing the another Read/Write command.

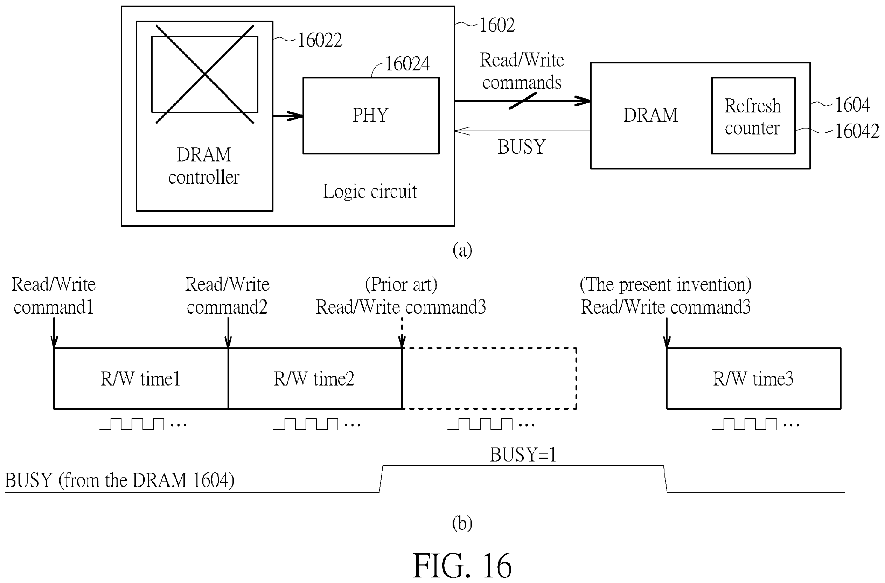

Next, please refer to FIG. 16. FIG. 16(a) is a diagram illustrating a logic circuit 1602 and a DRAM (e.g. DDR2, 3, 4, 5 or low power DDR2, 3, 4) 1604, and FIG. 16(b) is a timing diagram of the DRAM 1604 corresponding to Read(R)/Write(W) command1-3, R/W time1~3, and a signal of an output pin BUSY of DRAM according to one embodiment of the present invention. As shown in FIG. 16(a), there is no a refresh counter inside a DRAM controller 16022 of the logic circuit 1602 of the present invention, thus, it will not issue refresh command to the DRAM 1604. However, a refresh counter 16042 is still inside the DRAM 1604, the DRAM 1604 can calculate the time to execute refresh automatically according to number of clocks(clks) counted by the refresh counter 16042. A difference between the conventional DRAM 1404 and the present DRAM 1604 is that the DRAM 1604 has the extra output pin BUSY, and for example, the signal of the output pin BUSY is active (such as, the signal of the output pin BUSY is goes high or "1") during a refresh period of the DRAM 1604 (or the DRAM 1604 is executing a refresh operation), and the signal of the output pin BUSY is non-active (such as, the signal of the output pin BUSY is goes low or "0") when the DRAM 1604 does not perform refresh operation. Besides the output pin BUSY, any configuration which can provide handshaking method executed between the DRAM and the logic circuit 1602 still falls within the scope of the present invention. In addition, because the DRAM 1604 can execute refresh automatically, a DRAM controller 16022 of the logic circuit 1602 no longer need to control refresh of the DRAM 1604.

Therefore, as shown in FIG. 16(b), after a Read(R)/Write(W) command1 is issued by the DRAM controller 16022, R/W time1 is required for reading/writing from/to the DRAM 1604. Meanwhile, because the DRAM 1604 does not perform refreshing operation at this moment, the signal of the output pin BUSY goes low and the DRAM controller 16022 can issue a next Read(R)/Write(W) command2 to the DRAM 1604 according to a status (low) of the signal of the output pin BUSY. Then, R/W time2 is another time for reading/writing from/to the DRAM 1604. As shown in FIG. 16(b), during the R/W time2, when the DRAM 1604 needs refresh, the signal of the output pin BUSY will go high, resulting the DRAM controller 16022 to store another Read(R)/Write(W) commands into an extra register (e.g. FIFO and not shown in FIG. 16(a)) of the logic circuit 1602 and to issue NOP (No Operation) during the signal of the output pin BUSY is high. Afterward, as shown in FIG. 16(b), when the signal of the output pin BUSY goes low, the DRAM controller 16022 can issue the stored Read(R)/Write(W) commands to the DRAM 1604, and R/W time3 is another time for reading/writing from/to the DRAM 1604. Thus, the TR time for refresh after receiving refresh command from the DRAM controller in FIG. 14(b) of the conventional DDRAM is no more required.

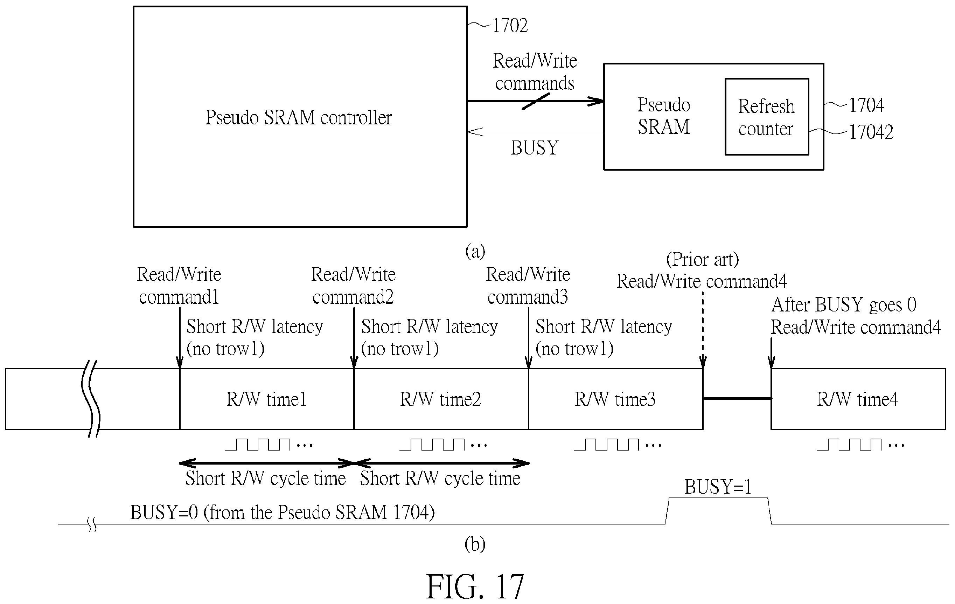

Next, please refer to FIG. 17. FIG. 17(a) is a diagram illustrating a pseudo SRAM controller 1702 and a pseudo SRAM (or other memory with DRAM memory cells inside) 1704 according to the present invention, and FIG. 17(b) is a timing diagram of the pseudo SRAM 1704 corresponding to Read(R)/Write(W) command1-4, R/W time1~4, and a signal of an output pin BUSY of pseudo SRAM according to one embodiment of the present invention. Similar to FIG. 16(a), as shown in FIG. 17(a), because a refresh counter 17042 inside the pseudo SRAM 1704 and there is no a refresh counter inside the pseudo SRAM controller 1702, the pseudo SRAM 1704 can execute refresh automatically according to number of clocks(clks) counted by the refresh counter 17042. In addition, similar to the DRAM 1604, the pseudo SRAM 1704 also has the extra output pin BUSY to inform the pseudo SRAM controller 1702 whether the pseudo SRAM 1704 is under refresh operation. In addition, because the pseudo SRAM 1704 can execute refresh automatically and inform its refresh status to the pseudo SRAM controller 1702 through the extra output pin BUSY, the pseudo SRAM 1704 does not need to wait a time trow1 (shown in FIG. 15(b)) which will cause no extra R/W latency and no longer R/W cycle time.

As shown in FIG. 17(b), after Read(R)/Write(W) command1 is issued by the pseudo SRAM controller 1702, R/W time1 is required for reading/writing from/to the pseudo SRAM 1704. However, time trow1 is not required. Meanwhile, at this moment the pseudo SRAM 1704 does not perform refresh operation, the signal of the output pin BUSY goes low and the pseudo SRAM controller 1702 can issue a next Read(R)/Write(W) command2 to the pseudo SRAM 1704 according to a status (low) of the signal of the output pin BUSY. Then, R/W time2 is another time for reading/writing from/to the pseudo SRAM 1704, however, time trow1 is not required. Then, when the signal of the output pin BUSY is still low, the pseudo SRAM controller 1702 can issue a next Read(R)/Write(W) commands to the pseudo SRAM 1704 and R/W time3 is another time for reading/writing from/to the pseudo SRAM 1704. As shown in FIG. 17(b), during the R/W time3, the pseudo SRAM 1704 needs refresh, so the signal of the output pin BUSY goes high, resulting the pseudo SRAM controller 1702 to store a next Read(R)/Write(W) command4 into an extra register (e.g. FIFO) and to issue NOP (No Operation) during the signal of the output pin BUSY is high. Afterward, as shown in FIG. 17(b), when the signal of the output pin BUSY goes low, the pseudo SRAM controller 1702 can issue the stored Read(R)/Write(W) command4 the pseudo SRAM 1704 and R/W time4 is another time for reading/writing from/to the pseudo SRAM 1704.

To sum up, compared to the prior art, the multi-layers configuration connecting the memory and the logic circuit can applied to the tiny substrate to make an area of the tiny substrate efficiently used, and the signal of the extra output pin for noticing refresh status can efficiently reduce R/W latency time during refresh of the DRAM.

## Claims

1. A memory chip comprising:
a memory bank;
an I/O data bus; and
**characterized by**:
a first plurality of sensing amplifiers between the memory bank and the I/O data bus, the first plurality of sensing amplifiers configured to output a first plurality of data in parallel to the I/O data bus;
wherein there is no parallel-to-serial circuit and no serial-to- parallel circuit in the memory chip.

2. The memory chip of claim 1, **characterized in that** the memory chip sends out a handshaking signal to selectively notice whether the memory chip does not execute a refresh operation.

3. The memory chip of claim 2, further **characterized by** an extra output pin, wherein the handshaking signal is sent to a memory controller through the extra output pin, wherein the memory controller is physically separate from the memory chip.

4. The memory chip of claim 2, further **characterized by** a refresh counter, wherein the handshaking signal is selectively active according to number of clocks counted by the refresh counter.

5. The memory chip of claim 2, **characterized in that** the handshaking signal is active when the DRAM chip is executing the refresh operation, and the handshaking signal is non-active when the DRAM chip does not execute the refresh operation.

6. The memory chip of claim 1, **characterized in that** a width of the I/O data bus is equal to a width of the first plurality of data parallelly outputted by the first plurality of sensing amplifiers.

7. The memory chip of claim 1, further **characterized by** a plurality of transceivers between the first plurality of sensing amplifiers and the I/O data bus, wherein the plurality of transceivers parallelly receive and transmit the first plurality of data from the first plurality of sensing amplifiers to the I/O data bus.

8. The memory chip of claim 7, further **characterized by** a second plurality of sensing amplifiers between the memory bank and the first plurality of sensing amplifiers, wherein the second plurality of sensing amplifiers comprise M sensing amplifiers and are connected to bit lines of the memory chip, the first plurality of sensing amplifiers comprise N sensing amplifiers and are connected to data lines of the memory chip, both N and M are positive integers, and M is not less than N.

9. The memory chip of claim 8, **characterized in that** a portion of the second plurality of sensing amplifiers are selectively coupled to the first plurality of sensing amplifiers, and the portion of the second plurality of sensing amplifiers parallelly output the first plurality of data to the first plurality of sensing amplifiers; wherein a number of sensing amplifiers in the portion of the second plurality of sensing amplifiers is equal to N.

10. The memory chip of claim 9, **characterized in that** the portion of the second plurality of sensing amplifiers are selectively coupled to the first plurality of sensing amplifiers according to a control signal inputted to the memory chip.

11. The memory chip of claim 10, **characterized in that** the control signal includes a plurality of signal bits configured to be stored in a register of the memory chip.

12. The memory chip of claim 10, further **characterized by** a plurality of bit switches between the first plurality of sensing amplifiers and the second plurality of sensing amplifiers, wherein the plurality of bit switches electrically connect to the portion of the second plurality of sensing amplifiers and the first plurality of sensing amplifiers according to the control signal.

13. A memory controller for a DRAM system, the DRAM system comprising a system bus interface and a memory chip, the memory chip comprising an I/O data bus, the memory controller comprising:
a control circuit configured to couple to the system bus interface; and
**characterized by**:
a physical layer circuit coupled to control circuit and configured to parallelly receive a first plurality of data from the I/O data bus of the memory chip;
wherein there is no serial-to-parallel circuit and no parallel-to-serial circuit in the physical layer circuit of the memory controller.

14. The memory controller of claim 13, **characterized in that** the physical layer circuit is further configured to parallelly output a second plurality of data to the I/O data bus of the memory chip.

15. The memory controller of claim 13, **characterized in that** the memory controller receives a handshaking signal from the memory chip to selectively notice the memory controller whether the memory chip does not execute a refresh operation.

16. The memory controller of claim 15, **characterized in that** the handshaking signal is active when the DRAM chip is executing the refresh operation, and the handshaking signal is non-active when the DRAM chip does not execute the refresh operation.

17. The memory controller of claim 16, **characterized in that** when the handshaking signal is active, the memory controller holds an access command which is intended to read data from or write data to the memory chip.

18. The memory controller of claim 17, **characterized in that** the memory controller sends the held access command to the memory chip after the handshaking signal is non-active.

19. A memory system comprising:
a system bus interface;
**characterized by**
a memory controller with a controller I/O data bus coupled to a plurality of second bump groups, wherein the memory controller is coupled to the system bus interface, the memory controller further comprises a physical layer, and there is no parallel-to-serial circuit and no serial-to-parallel circuit in the physical layer of the memory controller;
a memory chip with a memory I/O data bus coupled to a plurality of first bump groups, wherein the memory chip is coupled to the memory controller, there is no parallel-to-serial and no serial-to-parallel circuit in the memory chip; and
a substrate, wherein the memory controller and the memory chip are disposed on the substrate and horizontally space apart from each other.

20. The memory system of claim 19, **characterized in that** the plurality of first bump groups are arranged in side-by-side order, the plurality of second bump groups are arranged in side-by-side, each bump group of the plurality of first bump groups is connected to a corresponding bump group of the plurality of second bump groups through a corresponding track inside the substrate, and the tracks connected the plurality of first bump groups to the plurality of second bump groups do not cross each other.

21. A memory chip comprising:
a first set of memory banks; and
**characterized by**
an I/O data bus of the memory chip electrically coupled to the first set of memory banks, wherein each memory bank transmits a first predetermined width of data to the I/O data bus in parallel, a width of the I/O data bus is equal to a sum of the first predetermined width of data of each memory bank of the first set of the memory banks, and the first predetermined width is programmable according to a set of control signals;
wherein there is no parallel-to-serial and no serial-to-parallel circuit in the memory chip.

22. The memory chip of claim 21, further **characterized by** a second set of memory banks, wherein each memory bank of the second set of memory banks transmits a second predetermined width of data to the I/O data bus in parallel, the width of the I/O data bus is selectively equal to, based on a selection signal, the sum of the first predetermined width of data of each memory bank of the first set of the memory banks or a sum of the second predetermined width of data of each memory bank of the second set of the memory banks.

23. The memory chip of claim 22, **characterized in that** when the width of the I/O data bus is equal to the sum of the second predetermined width of data of each memory bank of the second set of the memory banks, the second predetermined width is programmable according to the set of control signals.
